# EUROPÄISCHE PATENTSCHRIFT

(11) **EP 3 076 188 B1**
(45) Veröffentlichungstag und Bekanntmachung des Hinweises auf die Patenterteilung: **08.03.2023**
(21) Anmeldenummer: 16000743.1
(22) Anmeldetag: 30.03.2016
(51) Int. Cl.: G01R 1/04, H01R 12/79, H01R 13/24

(54) **TEST-CONTACTOR, VERFAHREN UND VERWENDUNG**
TEST CONTACTOR, METHOD AND USE
CONTACTEUR DE TEST, PROCEDE ET UTILISATION

(30) Priorität: 30.03.2015 DE 102015004160
(43) Veröffentlichungstag der Anmeldung: 05.10.2016
(73) Patentinhaber: Yamaichi Electronics Deutschland GmbH, 85609 Aschheim-Dornach (DE)
(72) Erfinder: Quiter, Michael, 57482 Wenden (DE); Lassoued, Walid Ben, 85609 Aschheim-Dornach (DE)
(74) Vertreter: Müller-Boré & Partner Patentanwälte PartG mbB

(56) Entgegenhaltungen:
- DE-A1-102005 022 291
- KR-A- 20120 113 523
- US-A- 4 068 912
- US-B1- 6 619 979

## Beschreibung

Die vorliegende Erfindung betrifft einen Test-Contactor, sowie ein entsprechendes Verfahren und eine Verwendung.

Bei der Herstellung elektronischer Bauteile ist es oft notwendig, die Funktionalität dieser Bauteile vor dem Einbau in eine Vorrichtung separat zu testen. Die elektronischen Bauteile weisen des Öfteren Flachbandkabel auf, welche zum Testen mit einer Testelektronik verbunden werden müssen. Hierzu können sogenannte "Test-Contactoren" verwendet werden, welche die Verbindung zwischen dem zu prüfenden elektronischen Bauteil und der Testelektronik herstellen. Die Handhabung solcher Test-Contactoren ist bislang jedoch recht aufwendig, und die bisherigen Test-Contactoren weisen oft eine geringe Lebensdauer auf.

US 6 619 979 B1 offenbart eine Einsteckbuchse des Oberseiten-kontaktierenden Typs für Flachkabel.

Der vorliegenden Erfindung liegt die Aufgabe zugrunde, einen verbesserten Test-Contactor bereitzustellen, welcher einfach in der Handhabung ist und eine hohe Lebensdauer aufweist.

Gemäß einem Aspekt der vorliegenden Erfindung wird ein Test-Contactor gemäß Anspruch 1 bereitgestellt. Gemäss weiterer Aspekte wird ein entsprechendes Verfahren nach Anspruch 8 und eine entsprechende Verwendung nach Anspruch 9 bereitgestellt.

Durch die erfindungsgemäße Konfiguration können die freigelegten Litzen des Flachbandkabels unmittelbar mit den Kontaktpins des Test-Contactors elektrisch kontaktiert werden. So müssen die Litzen nicht in aufwendiger Weise mit einem Verbinder versehen werden. Dadurch entfällt auch die Notwendigkeit des Vorsehens eines entsprechenden komplementären Verbinders auf der Seite des Test-Contactors. Dies führt zu einer erheblich verbesserten Lebensdauer des Test-Contactors, da Verbinder nur eine gewisse Anzahl an Steckund Lösevorgängen ertragen können.

Der Test-Contactor kann auch als "Test-Kontaktierer" bezeichnet werden. Der Test-Contactor dient dazu, die Litzen des Flachbandkabels mit Kontaktpins elektrisch zu verbinden. Die Kontaktpins sind mit Leiterbahnen eines PCB (printed circuit board) bzw. einer Leiterplatine verbunden, wobei die Leiterbahnen wiederum mit einer Testelektronik oder einem Verbinder zum Verbinden mit einer Testelektronik verbunden sein können. Das Flachbandkabel kann ein Flachbandkabel eines zu testenden elektronischen Bauteils sein.

Die Basis des Test-Contactors kann den Hauptkörper des Test-Contactors darstellen. Die Basis kann mehrteilig ausgebildet sein. Die Pin-Ausnehmungen erstrecken sich durch die Basis hindurch, in einer Richtung senkrecht zur flachen Seite des Flachbandkabels in der Einführendposition. Die Pin-Ausnehmungen können zylindrisch ausgebildet sein, oder auch eine andere Querschnittsform aufweisen. Die Kontaktpins sind aus elektrisch leitendem Material hergestellt, und können nadelförmig bzw. zylindrisch ausgebildet sein. Die Kontaktpins erstrecken sich jeweils durch eine entsprechende Pin-Ausnehmung. Es können beispielsweise 26 Kontaktpins vorgesehen sein, wobei in dem Fall ebenfalls 26 Pin-Ausnehmungen und 26 Litzen des Flachbandkabels vorhanden sind. Es ist jedoch jede Anzahl von Kontaktpins möglich, beispielsweise 2 bis 100 Kontaktpins, abhängig von der Litzenanzahl des Flachbandkabels des zu testenden elektronischen Bauteils. Die Kontaktpins bzw. die Pin-Ausnehmungen sind vorzugsweise in einer Linie nebeneinander angeordnet, wobei der Abstand der Kontaktpins bzw. der Pin-Ausnehmungen zueinander dem Abstand der Litzen des Flachbandkabels angepasst ist.

Die Form der Andrückplatte ist nicht auf eine Plattenform beschränkt und kann daher auch als "Andrückkörper" oder "Andrückelement" bezeichnet werden. Die Andrückplatte kann an der Basis drehbar gelagert sein, beispielsweise mittels eines Drehgelenks. Der Test-Contactor kann derart ausgebildet sein, dass die Andrückplatte lediglich zwischen der Offenposition und der Schließposition verlagerbar ist. Die Offenposition und die Schließposition der Andrückplatte kann auch als Offenposition und Schließposition des Test-Contactors aufgefasst werden. Die Andrückplatte weist eine Andrückfläche auf, welche der Basis zugewandt ist, und welche in der Offenposition als Teil der Kabelführung das Flachbandkabel führt, und in der Schließposition das Flachbandkabel an eine Auflagefläche der Basis und an die Kontaktpins drückt und somit das Flachbandkabel festklemmt. In der Schließposition bilden die Basis und die Andrückplatte also eine Kabeleinspannung aus.

Die Andrückfläche der Andrückplatte und die Auflagefläche der Basis bilden in der Offenposition jeweils eine obere Führungsfläche und eine untere Führungsfläche der Kabelführung aus. Wenn in der vorliegenden Beschreibung und in den Ansprüchen Richtungs- bzw. Positionsangaben wie unten, oben, zur Seite usw. angegeben werden, so beziehen sich diese Angaben auf den Fall, dass der Test-Contactor auf einer horizontalen Ebene abgestellt ist, und die breite Fläche des Flachbandkabels sich beim Einführen in die Kabelführung und in der Einführendposition in der horizontalen Ebene befindet.

Durch die verdrehte Lage der Andrückplatte relativ zur Basis in der Offenposition ist die obere Führungsfläche zur Horizontalen geneigt, so dass das vordere Ende des Flachbandkabels beim Einführen in Richtung der Kontaktpins geführt werden kann. Die Kontaktpins bzw. die Pin-Ausnehmungen sind vorzugsweise in einem hinteren Abschnitt der Kabelführung in Einführrichtung des Flachbandkabels und vor dem Endanschlag in der Basis angeordnet. Der Endanschlag kann als Kante an der Andrückplatte und/oder an der Basis ausgebildet sein.

Die Seitenführungen sind in einem Abstand zueinander angeordnet, welcher in etwa der Breite des Flachbandkabels entspricht. Für eine gute Führung des Flachbandkabels kann die Länge der Kabelführung, also die Einstecktiefe des Flachbandkabels, etwa der Breite des Flachbandkabels entsprechen.

Die Vorderkante des Flachbandkabels verläuft senkrecht zur Längsrichtung des Flachbandkabels. Die Litzen sind vorzugsweise an der Vorderkante freigelegt. "Freigelegt" bedeutet, dass dort die Isolierung und ggf. die Abschirmung der jeweiligen elektrisch leitfähigen Litzen des Flachbandkabels entfernt sind.

Vorzugsweise weist die Basis eine Einführausnehmung auf, wobei die Seitenführungen und der Endanschlag in der Einführausnehmung ausgebildet sind, wobei die Andrückplatte einen vorspringenden Andrückabschnitt aufweist, wobei der Andrückabschnitt in der Schließposition zumindest teilweise in der Einführausnehmung angeordnet ist.

Die Einführausnehmung kann als Vertiefung in der Basis ausgebildet sein, wobei die Einführausnehmung nach vorne, also in einer Richtung entgegen der Einführrichtung des Flachbandkabels, sowie nach oben offen ist. Die hintere Wand der Einführausnehmung bildet den Endanschlag, und die zwei Seitenwände bilden die Seitenführungen. Der nach vorne offene Abschnitt der Einführausnehmung bildet zumindest zum Teil die Einführöffnung. Der Boden der Einführausnehmung bildet die Auflagefläche der Basis bzw. die untere Führungsfläche der Kabelführung. Die Kontaktpins bzw. die Pin-Ausnehmungen sind in dem Boden der Einführausnehmung angeordnet.

Die Einführausnehmung der Basis kann auf einer sogenannten "Floating Base" der Basis ausgebildet sein. Die Floating Base kann auch als Federplatte bezeichnet werden und stellt ein Bauteil der Basis dar, welches relativ zum Rest der Basis, zum Basishauptteil, in vertikaler Richtung federnd und verlagerbar gelagert ist, und zwischen einer abgesenkten Stellung und einer angehobenen Stellung verlagerbar ist. Durch Federn oder dergleichen kann die Floating Base in Richtung der angehobenen Stellung vorgespannt werden, so dass die Grundstellung der Floating Base die angehobene Stellung ist. Die Pin-Ausnehmungen erstrecken sich durch die Floating Base und das Basishauptteil hindurch. In der angehobenen Stellung stehen die Kontaktpins jedoch nicht von den Pin-Ausnehmungen der Floating Base nach oben hervor. Wenn die Andrückplatte von der Offenposition in die Schließposition verlagert wird, drückt die Andrückplatte die Floating Base nach unten in die abgesenkte Stellung, wobei in der abgesenkten Stellung die Kontaktpins aus den Pin-Ausnehmungen der Floating Base hervorstehen, um die Litzen kontaktieren zu können. In der angehobenen Stellung, also in der Offenposition der Andrückplatte, schützt die Floating Base so die Kontaktpins vor ungewolltem Kontakt und Beschädigungen. Ferner wird durch die Floating Base die Kontaktierung der Kontaktpins mit den Litzen beim Verlagern der Andrückplatte von der Offenposition in die Schließposition verbessert, da das Flachbandkabel in eine Kabelführung ohne hindernde Kontaktpins eingeführt und sauber in die Einführendposition gebracht werden kann.

Vorzugsweise weist der Test-Contactor weiter ein Vorspannungselement auf, welches eine Vorspannung auf die Andrückplatte in Richtung der Schließposition bewirkt.

Das Vorspannelement kann beispielsweise eine Feder, insbesondere eine Zugfeder sein, welche zwischen der Basis und der Andrückplatte angeordnet ist, oder Teil der Basis und/oder der Andrückplatte ist. Das Vorspannelement hält die Andrückplatte in der Schließposition, solange keine äußere Kraft auf die Andrückplatte ausgeübt wird. Die Schließposition kann daher auch als Grundposition bezeichnet werden. Durch Ausüben einer äußeren Kraft auf die Andrückplatte und/oder die Basis kann die Andrückplatte von der Schließposition in die Offenposition verlagert werden.

Vorteilhafterweise kann durch das Vorspannungselement eine kontrollierte Schließkraft auf die Andrückplatte und somit auch eine kontrollierte Andrückkraft auf die Litzen des Flachbandkabels ausgeübt werden, da der Benutzer beim Verlagern der Andrückplatte von der Offenposition in die Schließposition lediglich die auf die Andrückplatte wirkende äußere Kraft wegnehmen muss. Somit wird verhindert, dass der Benutzer beim Schließen des Test-Contactors eine zu hohe Kraft auf die Kontaktpins und die Litzen ausübt, was zu Beschädigungen der Kontaktpins und/oder der Litzen führen kann, oder eine zu niedrige Kraft auf die Kontaktpins und die Litzen ausübt, was zu mangelhaften Kontakten zwischen den Kontaktpins und den Litzen führen kann. Ferner wird durch das Vorspannungselement ausgeschlossen, dass der Benutzer vergisst, den Test-Contactor vor dem Testvorgang zu schließen.

Vorzugsweise weist der Test-Contactor weiter ein Betätigungselement auf, welches mit der Basis und der Andrückplatte gekoppelt ist, wobei durch Betätigung des Betätigungselements die Andrückplatte von der Schließposition in die Offenposition verlagerbar ist.

Das Betätigungselement kann ein Betätigungshebel sein, welcher an der Andrückplatte oder an der Basis drehbar gelagert sein kann. Das Betätigungselement kann bügelförmig ausgebildet sein, und beidseitig an der Andrückplatte oder an der Basis drehbar gelagert sein. Vorzugsweise weist das Betätigungselement eine Verlagerungsnase auf, welche sich an der Basis abstützt, und welche beim Verdrehen des Betätigungselements die Andrückplatte von der Basis wegdrückt. Vorzugsweise ist das Betätigungselement derart ausgebildet, dass durch Herunterdrücken des Betätigungselements die Andrückplatte von der Schließposition in die Offenposition verlagert werden kann.

Vorzugsweise ist die Andrückplatte im Wesentlichen transparent ausgebildet, so dass die Kabelführung durch die Andrückplatte hindurch visuell erkennbar ist.

Die Andrückplatte muss nicht vollständig transparent ausgebildet sein, es sollte lediglich die Kabelführung durch die Andrückplatte hindurch mit bloßem Auge identifizierbar sein. Die Andrückplatte kann hierzu auch lediglich abschnittsweise im Wesentlichen transparent ausgebildet sein.

Vorteilhafterweise wird durch die im Wesentlichen transparent ausgebildete Andrückplatte das korrekte Einführen des Flachbandkabels in die Kabelführung erleichtert. Insbesondere kann der Benutzer erkennen, ob das Flachbandkabel korrekt in die Einführendposition gebracht worden ist, also ob die Vorderkante des Flachbandkabels korrekt am Endanschlag anliegt. So kann eine fehlerhafte Kontaktierung vermieden werden.

Vorzugsweise ist die Kabelführung durch eine farblich hervorgehobene Führungsmarkierung begrenzt, wobei die Führungsmarkierung an der Basis und/oder an der Andrückplatte angeordnet ist.

Die Führungsmarkierung ist vorzugsweise an bzw. auf der Basis angeordnet, besonders vorzugsweise auf der Floating Base der Basis angeordnet. Die farbliche Hervorhebung kann mittels einer aufgebrachten bzw. eingebrachten Farbe erzeugt werden, wobei Weiß oder Schwarz ebenfalls als Farben angesehen werden. Die Führungsmarkierung muss lediglich zur Basis und zur Andrückplatte hervorgehoben, also erkennbar, sein. Dies kann ebenfalls mittels einer Rille oder dergleichen erfolgen, welche je nach Lichtverhältnissen als dunkle Hervorhebung wirkt. Vorzugsweise ist die Führungsmarkierung durch die im Wesentlichen transparente Andrückplatte erkennbar. Durch die Führungsmarkierung wird ein korrektes Einführen des Flachbandkabels in die Kabelführung und ein korrektes Anordnen des Flachbandkabels in die Einführendposition weiter vereinfacht.

Vorzugsweise weitet sich die Kabelführung im Bereich der Einführöffnung auf.

Insbesondere können sich die Seitenführungen im Bereich der Einführöffnung aufweiten. Hierdurch wird ein korrektes Einführen des Flachbandkabels in die Kabelführung weiter vereinfacht.

Die Basis ist auf einem PCB angeordnet.

Der PCB kann eine Elektronik, insbesondere eine Testelektronik bzw. Prüfelektronik, zum Testen des mit dem Flachbandkabel verbundenen elektronischen Bauteils aufweisen. Es kann jedoch auch lediglich ein Kabelanschluss auf dem PCB angeordnet sein, welches mit einem entsprechenden Anschluss einer Testelektronik verbunden werden kann. Vorzugsweise weist der PCB eine Vielzahl verschiedener Kabelanschlüsse auf, so dass verschiedene Testelektroniken mit dem PCB verbunden werden können.

Gemäß eines weiteren Aspekts der Erfindung wird ein Verfahren zum Verbinden eines Flachbandkabels mit einem Test-Contactor bereitgestellt, umfassend: - Bereitstellen eines vorstehend beschriebenen Test-Contactors; - Verlagern der Andrückplatte in die Offenposition; - Einführen des Flachbandkabels in die Kabelführung, bis das Flachbandkabel sich in der Einführendposition befindet; und - Verlagern der Andrückplatte in die Schließposition.

Vor dem Einführen des Flachbandkabels in die Kabelführung wurden die Litzen des Flachbandkabels freigelegt. Beim Verlagern der Andrückplatte in die Schließposition werden die Litzen mit den Kontaktpins kontaktiert.

Gemäß eines weiteren Aspekts der Erfindung wird eine Verwendung eines vorstehend beschriebenen Test-Contactors zum elektrischen Kontaktieren von freigelegten Litzen eines Flachbandkabels mit Kontaktpins bereitgestellt.

Insbesondere wird der Test-Contactor zum Verbinden der Litzen des Flachbandkabels mit einer Testelektronik verwendet. Genauer gesagt wird der Test-Contactor zum Testen eines mit dem Flachbandkabel verbundenen elektronischen Bauteils verwendet.

Das zum erfindungsgemäßen Test-Contactor gesagte gilt entsprechend auch für das erfindungsgemäße Verfahren und für die erfindungsgemäße Verwendung.

Im Folgenden wird eine Ausführungsform der vorliegenden Erfindung anhand der beiliegenden Figuren im Detail beschrieben. Es versteht sich, dass die vorliegende Erfindung nicht auf diese Ausführungsform beschränkt ist, und dass einzelne Merkmale der Ausführungsform im Rahmen der beiliegenden Ansprüche frei zu weiteren Ausführungsformen kombiniert werden können.

Es zeigen:
- **Fig. 1**: eine perspektivische Ansicht des Test-Contactors gemäß einer Ausführungsform;
- **Fig. 2**: eine perspektivische Ansicht des Basishauptteils des Test-Contactors;
- **Fig. 3**: eine perspektivische Ansicht der Basis des Test-Contactors;
- **Fig. 4**: eine weitere perspektivische Ansicht des Test-Contactors;
- **Fig. 5**: den Test-Contactor in der Schließposition in einer Seitenansicht;
- **Fig. 6**: den Test-Contactor in der Offenposition in einer Seitenansicht; und
- **Fig. 7**: den Test-Contactor in der Schließposition in einer Ansicht von vorne.

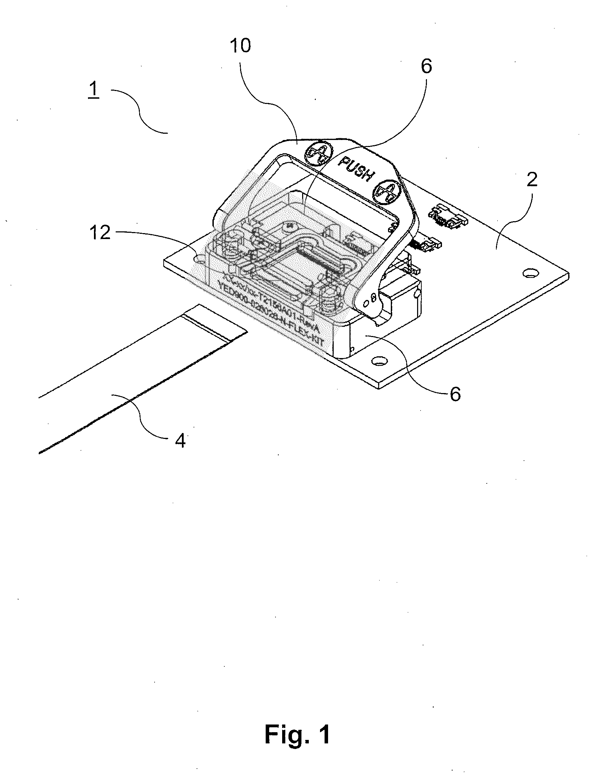

Fig. 1 zeigt eine perspektivische Ansicht des Test-Contactors 1 gemäß einer Ausführungsform. Der Test-Contactor 1 ist auf einem PCB (printed circuit board) bzw. einer Leiterplatine 2 angeordnet bzw. mit dieser verschraubt und dient im vorliegenden Fall dazu, die Litzen des Flachbandkabels 4 mit entsprechenden Leiterbahnen des PCB 2 zu verbinden. Das Flachbandkabel 4 bzw. die Litzen davon sind an dem nicht freien Ende davon mit einem nicht gezeigten elektronischen Bauteil verbunden.

Der Test-Contactor 1 weist eine Basis 6, eine Andrückplatte 8 und ein Betätigungselement 10 auf. Die Basis 6 und/oder die Andrückplatte 8 sind im Wesentlichen quaderförmig oder plattenförmig ausgebildet. Die Andrückplatte 8 ist an seinem, in Einführrichtung des Flachbandkabels 4 gesehen, hinteren Ende drehbar an dem hinteren Ende der Basis 6 gelagert. So kann die Andrückplatte 8 von einer Schließposition, wie sie in Fig. 1 gezeigt ist, in eine Offenposition verlagert bzw. aufgeklappt werden. In der Schließposition liegt die Andrückplatte 8 im Wesentlichen an der Basis 6 an. Die Andrückplatte 8 ist aus im Wesentlichen transparenten Material ausgebildet, so dass die Kabelführung 12 bzw. die Kabeleinspannung durch die Andrückplatte 8 hindurch erkennbar ist.

Das Betätigungselement 10 ist U-förmig bzw. bügelförmig ausgebildet und an seinen beiden Enden drehbar an der Andrückplatte 8 gelagert. Das Betätigungselement 10 erstreckt sich von der Andrückplatte 8 schräg nach oben und nach hinten. Durch Herunterdrücken des Betätigungselements 10 kann die Andrückplatte 8 von der Schließposition in die Offenposition verlagert werden.

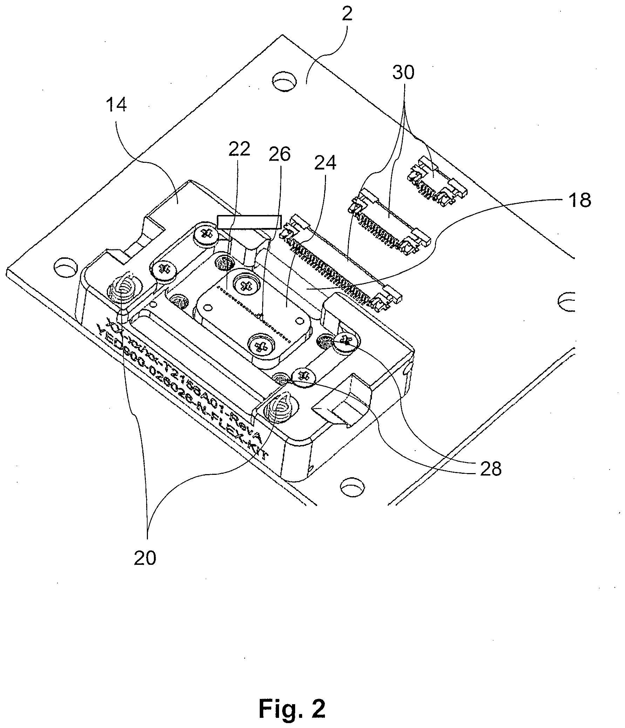

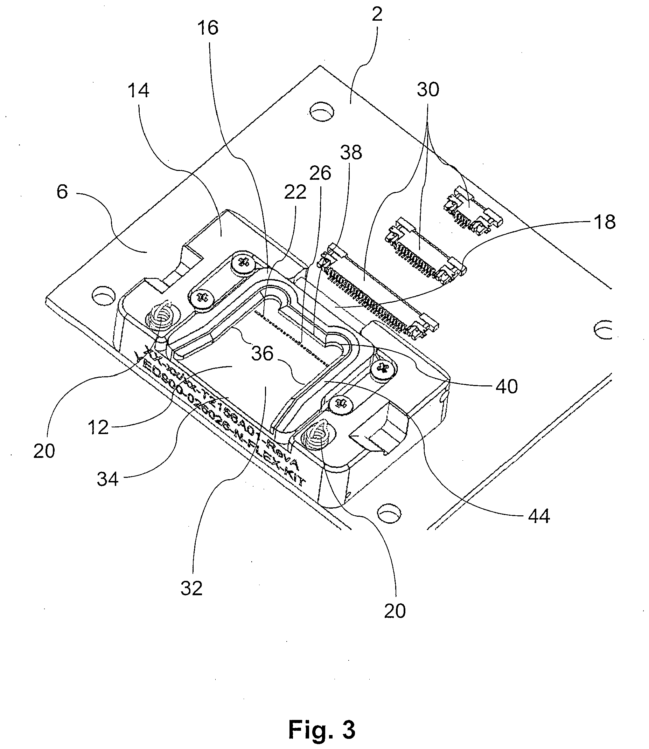

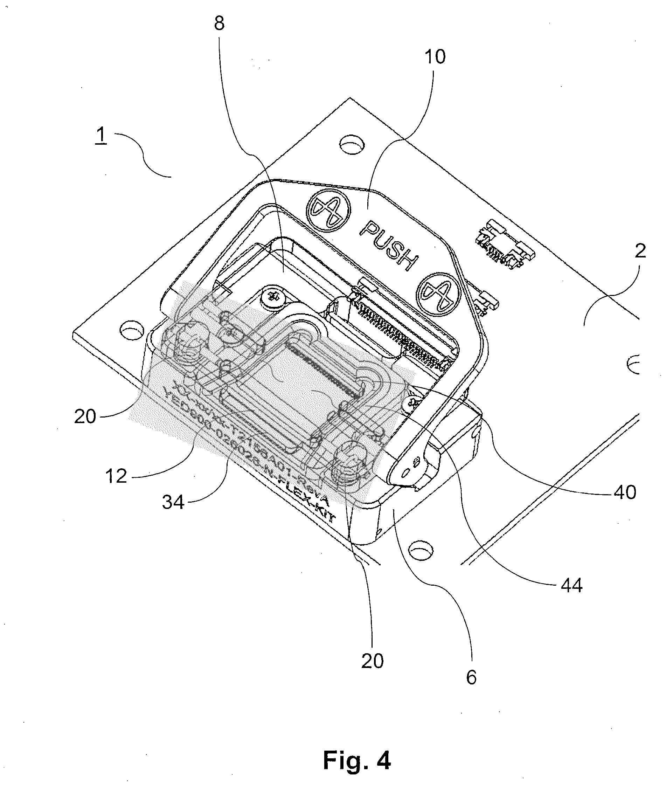

Fig. 2 zeigt eine perspektivische Ansicht des Basishauptteils 14 der Basis 6, und Fig. 3 zeigt eine perspektivische Ansicht der Basis 6, umfassend das Basishauptteil 14 und die Floating Base 16. In Fig. 2 ist die Floating Base 16 der Basis 6 also entfernt. Fig. 4 zeigt eine perspektivische Ansicht des Test-Contactors 1 umfassend die Basis 6, die Andrückplatte 8 und das Betätigungselement 10.

Das Basishauptteil 14 weist an seinem hinteren Ende eine Andrückplatte-Lagerwelle 18 zum drehbaren Lagern der Andrückplatte 8 auf. An seinem vorderen Ende weist das Basishauptteil 14 beidseitig, um die Kabelführung 12 herum angeordnet, zwei Vorspannungselemente 20 in Form von Schraubenfedern, insbesondere Zugfedern, auf. Die Vorspannungselemente 20 sind einerseits mit der Basis 6 bzw. dem Basishauptteil 14 verbunden und andererseits an dem anderen Ende mit der Andrückplatte 8 verbunden, und üben eine Zugkraft auf die Andrückplatte 8 in Richtung der Schließposition aus.

Das Basishauptteil 14 weist ferner eine Vielzahl von Pin-Ausnehmungen 22 auf, wobei diese in einem separaten Isolatorkörper 24 der Basis 6 vorgesehen sein können. In den Pin-Ausnehmungen 22 sind jeweils Kontaktpins 26 angeordnet, wobei der Einfachheit halber nur zwei Kontaktpins 26 in Fig. 2 und Fig. 3 angedeutet sind. Die Pin-Ausnehmungen 22 erstrecken sich auch durch die Floating Base 16 hindurch. Die Floating Base 16 ist über Floating-Federn 28, welche im Basishauptteil 14 angeordnet sind, in vertikaler Richtung federnd gelagert und kann zwischen einer angehobenen Stellung und einer abgesenkten Stellung verlagert werden. In der in Fig. 3 gezeigten Stellung befindet sich die Floating Base 16 in der abgesenkten Stellung, welche eingenommen wird, wenn die Andrückplatte 8 sich in der Schließposition befindet. In der abgesenkten Stellung stehen die Kontaktpins 26 aus den Pin-Ausnehmungen 22 der Floating Base 16 hervor. In der angehobenen Stellung der Floating Base 16 hingegen können die Kontaktpins 26 zwar in den Pin-Ausnehmungen 22 der Floating Base 16 angeordnet sein, jedoch stehen die Kontaktpins 26 nicht aus den Pin-Ausnehmungen 22 der Floating Base 16 hervor.

Die Kontaktpins 26 sind über die Leiterbahnen des PCB 2 mit den Kontakten der Kabelanschlüsse 30 verbunden. An die Kabelanschlüsse 30 können TestElektroniken bzw. Computer angeschlossen werden, um das mit dem Flachbandkabel 4 verbundene elektronische Bauteil zu testen.

Die Basis 6, insbesondere die Floating Base 16 davon, weist eine Einführausnehmung 32 zum Ausbilden der Kabelführung 12 auf, wobei die Einführausnehmung 32 bzw. die Kabelführung 12 eine nach vorne offene Einführöffnung 34, zwei Seitenführungen 36 und einen Endanschlag 38 aufweist. Im Bereich der Einführöffnung 34 weiten sich die Seitenführungen 36 auf. Die hintere Wand der Einführausnehmung 32, welche den Endanschlag 38 ausbildet, kann beidseitig halbkreisförmige Endanschlags-Ausnehmungen 40 aufweisen, welche bei einer spanenden Ausbildung der Einführausnehmung 32 erzeugt werden. Die Andrückplatte 8 weist in dem den Kontaktpins 26 zugewandten Bereich Pin-Freiräume 42 auf, welche eine Beschädigung der Kontaktpins 26 beim Schließen des Test-Contactors 1 verhindern.

Die Basis 6, insbesondere die Floating Base 16 davon, weist ferner eine Führungsmarkierung 44 auf, welche umlaufend entlang der Einführausnehmung 32 bzw. der Kabelführung 12 angeordnet ist. Die Führungsmarkierung 44 kann beispielsweise schwarz ausgebildet sein, wogegen die Basis 6 weiß oder beige ausgebildet sein kann, so dass die Führungsmarkierung 44 gegenüber der Basis 6 farblich hervorgehoben ist.

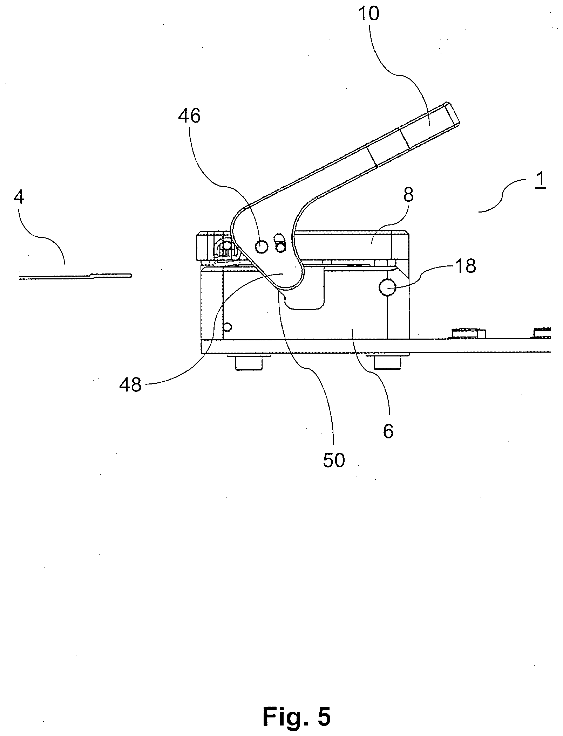

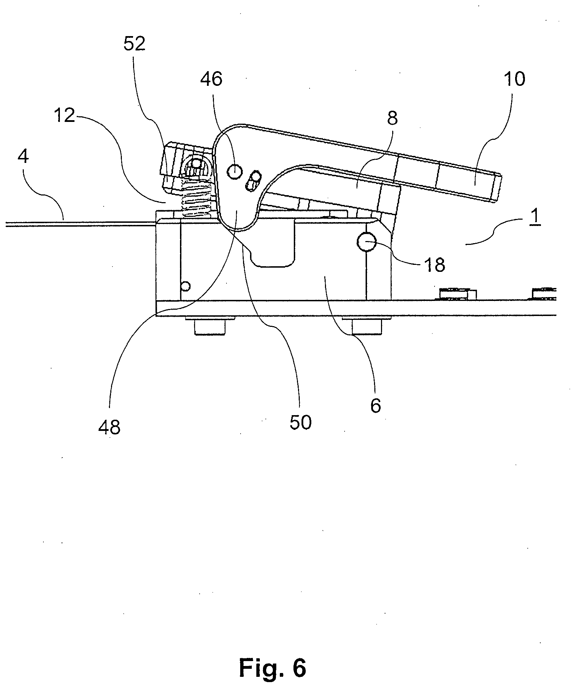

Fig. 5 zeigt den Test-Contactor 1 in der Schließposition in einer Ansicht von der Seite, vor dem Einführen des Flachbandkabels 4. Fig. 6 zeigt den Test-Contactor 1 in der Offenposition in einer Ansicht von der Seite, mit eingeführtem Flachbandkabel 4. Zum Öffnen des Test-Contactors 1, also zum Verlagern der Andrückplatte 8 von der Schließposition in die Offenposition, wird das Betätigungselement 10 heruntergedrückt, wobei das Betätigungselement 10 um die Betätigungselement-Lagerwelle 46 an der Andrückplatte 8 relativ zur Andrückplatte 8 verdreht wird. Das Betätigungselement 10 weist an seinen beiden Enden, also im Bereich der Lagerung zur Andrückplatte 8, jeweils eine Verlagerungsnase 48 auf. Die Verlagerungsnase 48 stützt sich jeweils an einer Abstützfläche 50 der Basis 6 ab und bei der Verdrehung des Betätigungselements 10 relativ zur Andrückplatte 8 drückt die Verlagerungsnase 48 die Andrückplatte 8 und die Basis 6 auseinander, so dass sich die Andrückplatte 8 um die Andrückplatte-Lagerwelle 18 herum relativ zur Basis 6 verdreht und in die Offenposition verlagert wird. In der Offenposition kann das Flachbandkabel 4 in die Kabelführung 12 bzw. in den Test-Contactor 1 eingeführt werden. Durch die Konfiguration der Verlagerungsnase 48 und der Abstützfläche 50 kann der Bewegungsverlauf des Öffnungs- bzw. des Schließvorgangs eingestellt werden.

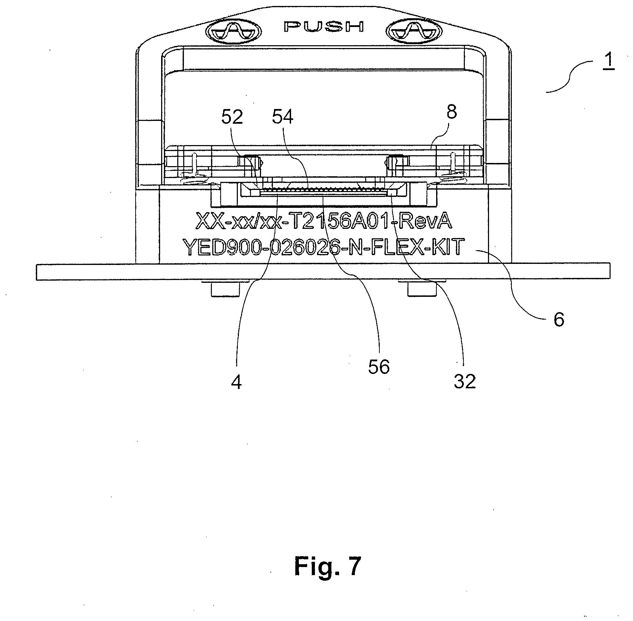

Fig. 7 zeigt den Test-Contactor 1 mit eingeführtem Flachbandkabel 4 in der Schließposition in einer Ansicht von vorne. Die Andrückplatte 8 weist einen vorspringenden Andrückabschnitt 52 auf, welcher in der Schließposition zumindest teilweise in der Einführausnehmung 32 angeordnet ist bzw. in diese hineinragt. In der Schließposition bildet die den Kontaktpins 26 zugewandte Fläche der Andrückplatte 8 bzw. des Andrückabschnitts 52 eine Andrückfläche 54 aus, welche die Litzen des Flachbandkabels 4 gegen die Kontaktpins 26 drückt und diese miteinander kontaktiert. Die der Andrückplatte 8 zugewandte Fläche der Basis 6 bzw. der Einführausnehmung 32 bildet in der Schließposition eine Auflagefläche 56 aus, die zusammen mit der Andrückfläche 54 der Andrückplatte 8 das Flachbandkabel 4 einklemmt bzw. festklemmt. In der Offenposition bildet die Andrückfläche 54 eine obere Führungsfläche und die Auflagefläche 56 eine untere Führungsfläche der Kabelführung 12 aus.

### Bezugszeichenliste

- 1: Test-Contactor
- 2: PCB
- 4: Flachbandkabel
- 6: Basis
- 8: Andrückplatte
- 10: Betätigungselement
- 12: Kabelführung
- 14: Basishauptteil
- 16: Floating Base
- 18: Andrückplatte-Lagerwelle
- 20: Vorspannungselement
- 22: Pin-Ausnehmung
- 24: Isolatorkörper
- 26: Kontaktpin
- 28: Floating-Federn
- 30: Kabelanschluss
- 32: Einführausnehmung
- 34: Einführöffnung
- 36: Seitenführung
- 38: Endanschlag
- 40: Endanschlags-Ausnehmung
- 42: Pin-Freiräume
- 44: Führungsmarkierung
- 46: Betätigungselement-Lagerwelle
- 48: Verlagerungsnase
- 50: Abstützfläche
- 52: Andrückabschnitt
- 54: Andrückfläche
- 56: Auflagefläche

## Patentansprüche

1. Test-Contactor (1) für ein Flachbandkabel (4), aufweisend:
- eine Basis (6) mit einer Vielzahl von Pin-Ausnehmungen (22);
- eine Vielzahl von Kontaktpins (26), welche jeweils in den Pin-Ausnehmungen (22) der Basis (6) angeordnet sind;
- eine Andrückplatte (8), welche relativ zur Basis (6) beweglich gelagert ist und zwischen einer Offenposition und einer Schließposition verlagerbar ist;
wobei die Basis (6) und die Andrückplatte (8) in der Offenposition eine Kabelführung (12) ausbilden, wobei die Kabelführung (12) eine Einführöffnung (34), Seitenführungen (36), eine obere Führungsfläche, eine untere Führungsfläche und einen Endanschlag (38) aufweist,
wobei ein Flachbandkabel (4) entlang seiner Längsrichtung durch die Einführöffnung (34) in die Kabelführung (12) einführbar ist und in eine Einführendposition bringbar ist, wobei in der Einführendposition eine Vorderkante des Flachbandkabels (4) am Endanschlag (38) anliegt,
wobei in der Schließposition freigelegte Litzen des in der Einführendposition befindlichen Flachbandkabels (4) durch die Andrückplatte (8) an die jeweiligen Kontaktpins (26) andrückbar sind,
wobei die Basis (6) auf einem PCB (2) angeordnet ist,
wobei eine Andrückfläche (54) der Andrückplatte (8) die obere Führungsfläche und eine Auflagefläche (56) der Basis (6) die untere Führungsfläche der Kabelführung (12) ausbilden,
wobei die Seitenführungen (36) in einem Abstand zueinander angeordnet sind, welcher in etwa der Breite des Flachbandkabels (4) entspricht,
wobei die Kontaktpins (26) mit Leiterbahnen des PCB (2) verbunden sind,
wobei sich die Pin-Ausnehmungen (22) in einer Richtung senkrecht zu einer flachen Seite des Flachbandkabels (4) in der Einführendposition durch die Basis (6) hindurch erstrecken, und
wobei die Kontaktpins (26) sich jeweils durch die entsprechenden Pin-Ausnehmungen (22) erstrecken.

2. Test-Contactor (1) nach Anspruch 1,
wobei die Basis (6) eine Einführausnehmung (32) aufweist, wobei die Seitenführungen (36) und der Endanschlag (38) in der Einführausnehmung (32) ausgebildet sind, und
wobei die Andrückplatte (8) einen vorspringenden Andrückabschnitt (52) aufweist, wobei der Andrückabschnitt (52) in der Schließposition zumindest teilweise in der Einführausnehmung (32) angeordnet ist.

3. Test-Contactor (1) nach einem der vorangehenden Ansprüche, weiter aufweisend ein Vorspannungselement (20), welches eine Vorspannung auf die Andrückplatte (8) in Richtung der Schließposition bewirkt.

4. Test-Contactor (1) nach einem der vorangehenden Ansprüche, weiter aufweisend ein Betätigungselement (10), welches mit der Basis (6) und der Andrückplatte (8) gekoppelt ist, wobei durch Betätigung des Betätigungselements (10) die Andrückplatte (8) von der Schließposition in die Offenposition verlagerbar ist.

5. Test-Contactor (1) nach einem der vorangehenden Ansprüche, wobei die Andrückplatte (8) im Wesentlichen transparent ausgebildet ist, so dass die Kabelführung (12) durch die Andrückplatte (8) hindurch visuell erkennbar ist.

6. Test-Contactor (1) nach einem der vorangehenden Ansprüche,
wobei die Kabelführung (12) durch eine farblich hervorgehobene Führungsmarkierung (44) begrenzt ist, und
wobei die Führungsmarkierung (44) an der Basis (6) und/oder an der Andrückplatte (8) angeordnet ist.

7. Test-Contactor (1) nach einem der vorangehenden Ansprüche, wobei sich die Kabelführung (12) im Bereich der Einführöffnung (34) aufweitet.

8. Verfahren zum Verbinden eines Flachbandkabels (4) mit einem Test-Contactor (1), umfassend:
- Bereitstellen eines Test-Contactors (1) nach einem der Ansprüche 1 bis 7;
- Verlagern der Andrückplatte (8) in die Offenposition;
- Einführen des Flachbandkabels (4) in die Kabelführung (12), bis das Flachbandkabel (4) sich in der Einführendposition befindet; und
- Verlagern der Andrückplatte (8) in die Schließposition.

9. Verwendung eines Test-Contactors (1) nach einem der Ansprüche 1 bis 7 zum elektrischen Kontaktieren von freigelegten Litzen eines Flachbandkabels (4) mit Kontaktpins (26).

## Claims

1. A test contactor (1) for a ribbon cable (4), comprising:
- a base (6) with a plurality of pin recesses (22);
- a plurality of contact pins (26), each of which are arranged in the pin recesses (22) of the base (6);
- a pressure plate (8), which is movably mounted relative to the base (6) and can be displaced between an open position and a closed position;
wherein the base (6) and the pressure plate (8) in the open position form a cable run (12), wherein the cable run (12) has an insertion opening (34), lateral guides (36), an upper guide surface, a lower guide surface, and an end stop (38),
wherein a ribbon cable (4) can be introduced into the cable run (12) along its longitudinal direction through the insertion opening (34) and can be brought into an inserting end position, wherein in the inserting end position a front edge of the ribbon cable (4) abuts the end stop (38),
wherein, in the closed position, exposed wires of the ribbon cable (4) in the inserting end position can be pressed to each of the contact pins (26) by means of the pressure plate (8),
wherein the base (6) is arranged on a PCB (2),
wherein a pressing surface (54) of the pressure plate (8) forms the upper guide surface and a support surface (56) of the base (6) forms the lower guide surface of the cable run (12),
wherein the lateral guides (36) are arranged at a distance to one another which approximately corresponds to the width of the ribbon cable (4),
wherein the contact pins (26) are connected with conductor paths of the PCB (2),
wherein the pin recesses (22) extend through the base (6) in a direction perpendicular to a flat side of the ribbon cable (4) in the inserting end position, and
wherein the contact pins (26) each extend through the corresponding pin recesses (22).

2. The test contactor (1) according to claim 1,
wherein the base (6) has an insertion recess (32), wherein the lateral guides (36) and the end stop (38) are formed in the insertion recess (32), and
wherein the pressure plate (8) has a protruding pressing section (52), wherein the pressing section (52) in the closed position is arranged at least partially in the insertion recess (32).

3. The test contactor (1) according to any of the preceding claims, further comprising a preloaded element (20) which causes a preload on the pressure plate (8) in the direction of the closed position.

4. The test contactor (1) according to any of the preceding claims, further comprising an actuating element (10) which is coupled with the base (6) and the pressure plate (8), wherein by actuating the actuation element (10), the pressure plate (8) can be displaced from the closed position into the open position.

5. The test contactor (1) according to any of the preceding claims, wherein the pressure plate (8) is designed substantially transparent, so that the cable run (12) is visually discernible through the pressure plate (8).

6. The test contactor (1) according to any of the preceding claims, wherein the cable run (12) is limited by a guide marking (44) highlighted in color, and
wherein the guide marking (44) is arranged on the base (6) and/or on the pressure plate (8).

7. The test contactor (1) according to any of the preceding claims, wherein the cable run (12) widens in the area of the insertion opening (34).

8. A method for connecting a ribbon cable (4) to a test contactor (1), comprising:
- providing a test contactor (1) according to any of the claims 1 to 7;
- displacing the pressure plate (8) into the open position;
- inserting the ribbon cable (4) into the cable run (12) until the ribbon cable (4) is in the inserting end position; and
- displacing the pressure plate (8) into the closed position.

9. Using a test contactor (1) according to any one of claims 1 to 7 to electrically contact exposed wires of a ribbon cable (4) having contact pins (26).

## Revendications

1. Contacteur de test (1) pour un câble plat (4), présentant :
une base (6) dotée d'un pluralité d'évidements de broche (22) ;
une pluralité de broches de contact (26) disposées respectivement dans les évidements de broche (22) de la base (6) ;
une plaque de pression (8) montée de façon détachable par rapport à la base (6) et déplaçable entre une position ouverte et une position fermée ;
dans lequel la base (6) et la plaque de pression (8) dans la position ouverte forment un guide de câble (12), dans lequel le guide de câble (12) présente une ouverture d'introduction (34), des guides latéraux (36), une surface de guidage supérieure, une surface de guidage inférieure et une butée finale (38),
dans lequel un câble plat (4) peut être introduit dans le guide de câble (12) à travers l'ouverture d'introduction (34) le long de sa direction longitudinale et peut être placé dans une position finale d'introduction, dans lequel un bord avant du câble plat (4) s'applique sur la butée finale (38) dans la position finale d'introduction,
dans lequel, dans la position fermée, des torons dénudés du câble plat (4) se trouvant dans la position finale d'introduction peuvent être pressés contre les broches de contact (26) respectives par la plaque de pression (8),
dans lequel la base (6) est disposée sur un circuit imprimé (2),
dans lequel une surface de pression (54) de la plaque de pression (8) forme la surface de guidage supérieure et une surface de pression (56) de la base (6) forme la surface de guidage inférieure du guide de câble (12),
dans lequel les guides latéraux (36) sont disposés à une distance l'un de l'autre, laquelle correspond approximativement à la largeur du câble plat (4),
dans lequel les broches de contact (26) sont reliées à des pistes conductrices du circuit imprimé (2),
dans lequel les évidements de broche (22) s'étendent à travers la base (6) dans une direction perpendiculaire à un côté plat du câble plat (4) dans la position finale d'introduction, et
dans lequel les broches de contact (26) s'étendent respectivement à travers les évidements de broche (22) correspondants.

2. Contacteur de test (1) selon la revendication 1,
dans lequel la base (6) présente un évidement d'introduction (32), dans lequel les guides latéraux (36) et la butée finale (38) sont formés dans l'évidement d'introduction (32), et
dans lequel la plaque de pression (8) présente une section de pression saillante (52), dans lequel la section de pression (52) dans la position fermée est disposée au moins partiellement dans l'évidement d'introduction (32).

3. Contacteur de test (1) selon l'une des revendications précédentes, présentant en outre un élément de précontrainte (20), lequel exerce une précontrainte sur la plaque de pression (8) en direction de la position fermée.

4. Contacteur de test (1) selon l'une des revendications précédentes, présentant en outre un élément d'actionnement (10), lequel est accouplé à la base (6) et à la plaque de pression (8), dans lequel un actionnement de l'élément d'actionnement (10) permet de déplacer la plaque de pression (8) de la position fermée vers la position ouverte.

5. Contacteur de test (1) selon l'une des revendications précédentes, dans lequel la plaque de pression (8) est réalisée essentiellement transparente, de sorte que le guide de câble (12) est visuellement reconnaissable à travers la plaque de pression (8).

6. Contacteur de test (1) selon l'une des revendications précédentes,
dans lequel le guide de câble (12) est délimité par un repère de guidage en couleur (44), et
dans lequel le repère de guidage (44) est disposé sur la base (6) et/ou sur la plaque de pression (8).

7. Contacteur de test (1) selon l'une des revendications précédentes, dans lequel le guide de câble (12) s'élargit dans la région de l'ouverture d'introduction (34).

8. Procédé de raccordement d'un câble plat (4) à un contacteur de test (1), comportant :
la mise à disposition d'un contacteur de test (1) selon l'une des revendications 1 à 7 ;
le déplacement de la plaque de pression (8) vers la position ouverte ;
l'introduction du câble plat (4) dans le guide de câble (12), jusqu'à ce que le câble plat (4) se trouve dans la position finale d'introduction ; et
déplacement de la plaque de pression (8) vers la position fermée.

9. Utilisation d'un contacteur de test (1) selon l'une des revendications 1 à 7 pour la mise en contact électrique de torons dénudés d'un câble plat (4) avec des broches de contact (26).
